# EUROPÄISCHE PATENTANMELDUNG

(11) **EP 0 947 835 A2**
(43) Veröffentlichungstag der Anmeldung: **06.10.1999**
(21) Anmeldenummer: 99112288.8
(22) Anmeldetag: 24.04.1995
(51) Int. Cl.: G01P 15/08

(54) **Mikrosystem mit einer dielektrischen beweglichen Struktur und Herstellverfahren**

(30) Priorität: 28.04.1994 DE 4414969
(62) Teilanmeldung aus: 95106100.1
(71) Anmelder: SIEMENS AKTIENGESELLSCHAFT, 80333 München (DE)
(72) Erfinder: Zettler, Thomas, 81737 München (DE)

(57) **Zusammenfassung**

Die Erfindung betrifft ein Mikrosystem mit einer integrierten Schaltung und einem mikromechanischen Bauteil mit beweglichem Dielektrikum, bei dem Schaltungselemente der Integrierten Schaltung mithilfe einer oder mehreren leitenden Schichten verdrahtet sind und bei dem das mikromechanische Bauteil ein Kondensatorplattenpaar umfaßt, das mithilfe dieser leitenden Schichten gebildet ist. Das Bauteil kann u.a. einen Motor mit dielektrischem Rotor oder einen proportionalen oder nicht-proportionalen Kraftsensor darstellen.

## Beschreibung

Die Erfindung betrifft ein Mikrosystem auf einem Halbleitersubstrat mit einer integrierten Schaltung und einem mikromechanischen Bauteil, wobei das mikromechanische Bauteil eine feste mikromechanische Struktur und eine bewegliche mikromechanische Struktur umfaßt, sowie ein Herstellverfahren.

Mikromechanische Bauteile werden zu verschiedenen Zwecken eingesetzt, ein wichtiges Anwendungsgebiet sind proportionale und nicht-proportionale Kraftsensoren (Beschleunigungs- und Neigungssensoren). Die bekannten derartigen Sensoren besitzen feste und bewegliche mikromecha-nische Strukturen und basieren auf der kapazitiven Messung der Variation des Elektrodenabstandes eines mikromechani-schen Kondensators. Bspw. wird in dem Artikel von Sherman et al., Conf. Proc. IEDM 1992, S.501 (Nr. 0-7803-0817-4/92 IEEE) eine Struktur vorgeschlagen, bei der sich eine beweglich aufgehängte Polysiliziumzunge zwischen zwei fest angebrachten Zungen befindet. Eine Beschleunigung verändert den Abstand der beweglichen Zunge relativ zu den festen Zungen, wodurch die Kapazität zu einer der festen Zungen zunimmt und zur anderen abnimmt. Diese Änderung wird elektrisch detektiert.

Bei der Herstellung von derartigen mikromechanischen Bauteilen besteht ein großes Interesse an Prozessen, die mit der Fertigung von integrierten Schaltungen, insbesondere auf einem Silizium-Substrat, kompatibel sind. Nur eine Kompatibilität der Herstellungsprozesse erlaubt die Integration von Mikromechanik und Ansteuer- oder Auswerteschaltungen in Mikrosystemen. Dies ist auch dann wichtig, wenn bestehende Halbleiterfertigungsanlagen auch zur Herstellung von mikromechanischen Strukturen genutzt werden sollen. Besonders vorteilhaft wäre ein Prozeß, mit dem gleichzeitig eine integrierte Schaltung und ein mikromechanisches Bauteil in verschiedenen Bereichen des Halbleitersubstrats erzeugt werden, d.h. ein Mikrosystem mit nur minimalem zusätzlichem Prozeßaufwand zur integrierten Schaltung hergestellt wird.

Für mikromechanische Bauteile sind u.a. folgende Herstellprozesse bekannt:
a) Polysilizium Center-pin- und Flange-Prozeß (M. Mehrengany, Y.-C. Tai, J. Micromech. Microeng., vol. 1, 73, 1991) Dieser Prozeß erfordert bei der Herstellung der mikromechanischen Strukturen im Anschluß an die Herstellung der integrierten Schaltung zusätzliche Polysiliziumabscheidungen nach dem Metallisierungskomplex. Im Fall, daß der Center-Pin-Prozeß vor der Metallisierung der integrierten Schaltung durchgeführt werden soll, ergibt sich das Problem, die beweglichen Strukturen freizuätzen, und gleichzeitig die Isolation der Metallisierung zu schützen. Ein weiterer Nachteil ist der relativ hohe spezifische Widerstand von dotiertem Polysilizium.
b) Polysilizium LOCOS-Prozeß (L.S. Tavrow et al, Sensors and Actuators A, Phys. vol. A35, 33, 1992):
   Der Prozeß sieht vor, die beweglichen mikromechanischen Strukturen auf einer planen LOCOS-Oxidschicht herzustellen, wobei der Oxidationsschritt wegen der Temperaturbelastung nur vor der Transistorherstellung einer integrierten Schaltung erfolgen kann. Bei vollständiger Durchführung des Prozesses vor Herstellung der integrierten Schaltung ergibt sich eine ungünstige Topologie für die Nachfolgeschritte sowie das Problem, die mikromechanischen Strukturen während der Herstellung der integrierten Schaltung zu schützen. Bei einer ineinander verzahnten Herstellung muß das Problem der Freiätzung des Rotors bei gleichzeitigem Schutz der Schaltungsisolationsoxide gelöst werden.
c) Selektiver Wolfram-Prozeß (L.Y.Chen et al, TRANSDUCERS '91., Int. Conf. on Solid-State Sensors and Actuators. San Francisco, USA, IEEE Cat. No. 91CH2817-5, 739, 1991):
   Dieser Prozeß kann im Anschluß an einen Schaltungs-Fertigungsprozeß durchgeführt werden, wobei das Problem der elektrischen Kontaktierung und des Schutzes der Metallisierungsisolation durch das vorgeschlagene Verfahren nicht gelöst werden. Der Prozeß ist insbesondere bezüglich der Lithographieschritte sehr aufwendig.
d) LIGA-Prozeß (P.Bley et al, Microelectronic Engineering 13, 509, 1991; H. Guckel et al, Conf. Proceedings IEEEMicro Electro Mechanical Systems, Nara, Japan, 1991): Dieser Prozeß benötigt Röntgenstrahl-Lithographie und eventuell eine nachträgliche Montage von losen mikroskopischen Bauteilen.

Alle diese Prozesse sind in ihrer Konzeption nicht für die gemeinsame und insbesondere gleichzeitige Fertigung von integrierter Schaltung und dem mikromechanischen Bauteil in einem Mikrosystem ausgelegt. Sie benötigen eine Vielzahl von Schichten und Prozeßschritten, welche ausschließlich der Herstellung des mikromechanischen Bauteils dienen und die für die Herstellung einer integrierten Schaltung überflüssig oder sogar einschränkend oder nachteilig sind.

Der Erfindung liegt daher die Aufgabe zugrunde, ein neuartiges Konzept für ein Mikrosystem mit einem mikromechanischen Bauteil anzugeben, wobei das Bauteil als Motor, Aktor oder Kraftsensor eingesetzt werden kann, sowie ein Herstellverfahren für ein Mikrosystem anzugeben, bei welchem ausgehend von der IS-Herstellung ein nur minimaler zusätzlicher Prozeßaufwand für die Herstellung des mikromechanischen Bauteils notwendig ist.

Diese Aufgabe wird durch die Merkmale der Ansprüche 1 und 10 gelöst.

Die Erfindung beruht auf der Kombination eines mikromechanischen Bauteils, das eine dielektrische bewegliche Struktur und ein aus einer oder mehreren leitenden Schichten gebildetes Kondensatorplattenpaar umfaßt, und einer integrierten Schaltung, deren Schaltungselemente mithilfe der leitenden Schicht oder Schichten verdrahtet sind. Die dielektrische bewegliche Struktur ist zwischen dem Kondensatorplattenpaar beweglich. Das mikromechanische Bauteil kann insbesondere einen Motor mit dielektrischem Rotor oder einen Kraftsensor darstellen.

Bei Einsatz als Kraftsensor wird die dielektrische bewegliche Struktur durch die zu messende Kraft zwischen das Kondensatorplattenpaar eingeführt, so daß dessen Kapazität sich ändert. Die Kapazitätsänderung wird gemessen. Umgekehrt kann die Kraft auch die Entfernung des Dielektrikums aus dem Zwischenraum bewirken. Die dielektrische Struktur kann frei oder federnd beweglich sein, so daß das Bauteil einen nichtproportionalen oder einen proportionalen Kraftsensor darstellt. Das Bauteilprinzip kann ebenso für Aktoren verwendet werden, da das Feld eines geladenen Kondensators auf das Dielektrikum eine Kraft ausübt. In jedem Fall ist ein Material mit hoher Dielektrizitätskonstante εr vorteilhaft, also z.B. Siliziumnitrid.

Bei dem erfindungsgemäßen Herstellverfahren wird das Kondensatorplattenpaar aus derselben oder aus verschiedenen leitenden Schichten, die bereit für die Verdrahtung der Integrierten Schaltung des Mikrosystems benötigt werden, strukturiert. Die bewegliche Struktur wird aus einer dielektrischen Schicht strukturiert. Feste und bewegliche Strukturen sind dabei durch eine isolierende Schicht voneinander getrennt. Dann wird eine Maske aufgebracht und ein Ätzprozeß mit einer isotropen Komponente durchgeführt, der die isolierende Schicht mindestens um das Dielektrikum herum selektiv zur festen Struktur entfernt. Nach dem Ätzprozeß ist das Dielektrikum frei oder federnd beweglich. Bei einer frei beweglichen mikromechanischen Struktur besitzt diese nach dem Ätzprozeß keine Verbindung mehr zum übrigen Bauteil. Bei einer federnd beweglichen mikromechanischen Struktur ist noch eine Verbindung vorhanden, und zwar vorzugsweise über einen seitlich herausgeführten Teil der dielektrischen Schicht mit geringer Querschnittsfläche, der auf seiner anderen Seite z.B. mit einer Befestigungsplatte verbunden ist und als Federelement zwischen beweglicher Struktur und Befestigungsplatte wirkt.

Mit dem Verfahren kann ein proportionaler oder nicht-proportionaler Kraftsensor oder ein Motor mit dielektrischem Rotor hergestellt werden. Im ersten Fall werden vorzugsweise übereinanderliegende leitende Schichten für das Kondensatorplattenpaar verwendet, so daß es im wesentlichen parallel zur Substratoberfläche angeordnet ist. Zwischen den leitenden Schichten befindet sich eine untere isolierende Schicht, die dielektrische Schicht und eine obere isolierende Schicht. Im letzten Fall werden ein oder mehrere Kondensatorplattenpaare vorzugsweise aus derselben leitenden Schicht strukturiert, die isolierende und die dielektrische Schicht aufgebracht und die dielektrische Schicht zu einer im Plattenzwischenraum (nach dem Ätzprozeß) frei beweglichen Struktur strukturiert; die dielektrische Struktur kann auch vor den Kondensatorplatten hergestellt werden. Ein nichtproportionaler Sensor kann je nach Anforderung mit beiden Konzepten realisiert werden.

Bei dem erfindungsgemäßen Mikrosystem werden eine oder mehrere leitende Schichten, die bereits für die Verdrahtung der integrierten Schaltung benötigt werden, als Teile des mikromechanischen Bauteils verwendet. Diese Schicht oder Schichten müssen lediglich durch ein entsprechendes Design so strukturiert werden, daß im Bereich des mikromechanischen Bauteils ein Kondensatorplattenpaar als feste mikromechanische Struktur gebildet wird. Die Herstellung der dielektrischen Struktur erfolgt i.a. in einem zur IS-Herstellung zusätzlichen Prozeßschritt, der isotrope Ätzprozeß wird bei der IS-Herstellung bereits zur Freiätzung der Anschlußpads benötigt. Die integrierte Schaltung kann eine Ein- oder Mehrlagenverdrahtung (d.h. eine oder mehrere Metallisierungsebenen) aufweisen, von denen eine, mehrere oder alle für das mikromechanische Bauteil verwendet werden können. Ferner kann die integrierte Schaltung in einer beliebigen Technologie, bspw. CMOS, ausgeführt werden.

Die Erfindung wird im folgenden anhand von Ausführungsbeispielen, die in den Figuren dargestellt sind, näher erläutert. Es zeigen:
- FIG 1 - 2: einen Querschnitt durch ein Halbleitersubstrat im Bereich des mikromechanischen Bauteils des Mikrosystems, an dem das Verfahren verdeutlicht wird,
- FIG 3: eine Aufsicht auf das mikromechanische Bauteil aus FIG 1
- FIG 4 - 6: einen Querschnitt durch bzw. eine Aufsicht auf ein mikromechanisches Bauteil des Mikrosystems gemäß einer weiteren Ausführungsform der Erfindung.

### FIG 1 - 3 :

Als erstes AusfÜhrungsbeispiel wird ein Mikrosystem beschrieben, bei dem das mikromechanische Bauteil als nichtproportionaler Kraftsensor eingesetzt werden kann. Das mikromechanische Bauteil besitzt ein im wesentlichen parallel zur Substratoberfläche (horizontal) angeordnetes Kondensatorplattenpaar, gebildet aus den leitenden Schichten 2 und 7, als festes mikromechanisches Bauteil sowie ein im wesentlichen horizontal bewegliches Dielektrikum 4 als frei bewegliches mikromechanisches Bauteil. vorzugsweise ist das Dielektrikum ringförmig ausgebildet und mit einer Sicherung gegen Herausfallen versehen, die aus der oberen leitenden Schicht gebildet werden kann.

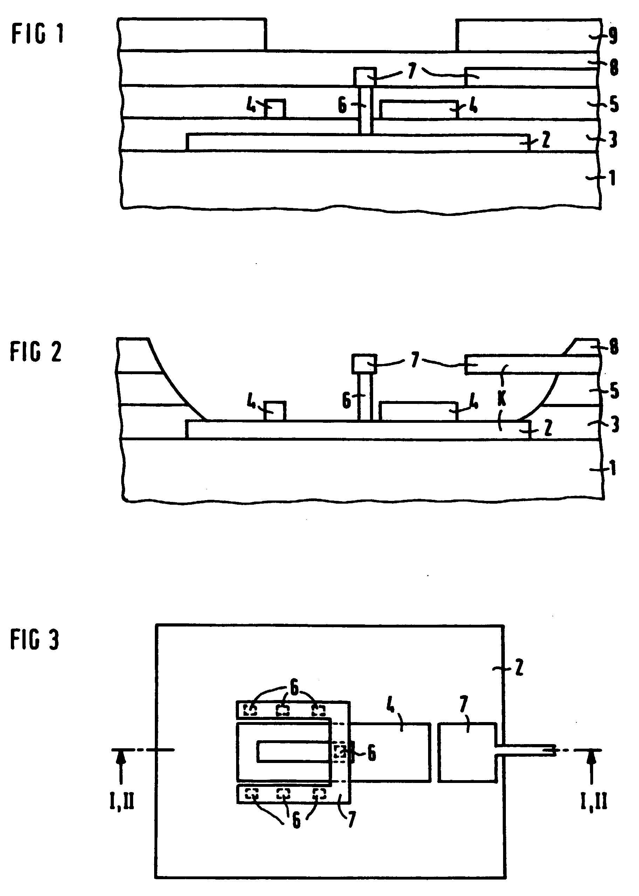

In FIG 1 ist ein Substrat 1 mit beliebiger Oberfläche (z.B. Silizium oder ein Feldoxid ) dargestellt. Auf dem Substrat wird eine untere leitende Schicht 2, bspw. eine Polysiliziumschicht oder eine erste Metallisierungsebene, aufgebracht und strukturiert. Die untere leitende Schicht 2 wird mit einer unteren isolierenden Schicht 3 abgedeckt, auf dieser wird eine dielektrische Schicht 4 aufgebracht und zur beweglichen Struktur strukturiert. Es wird eine obere isolierende Schicht 5 aufgebracht und ggf. mit Kontaktlöchern versehen, die dann mit einem geeigneten Material zu Kontakten 6 aufgefüllt werden. Im BT-Bereich dienen diese Kontakte zur Herstellung der (mechanischen) Sicherung, so daß ihr elektrischer Widerstand hier unwesentlich ist. Auf der oberen isolierenden Schicht 5 wird die obere leitende Schicht 7 aufgebracht und derart strukturiert, daß sie in einem vorgegebenen Bereich ein Kondensatorplattenpaar mit der unteren leitenden Schicht 2 bildet, also diese teilweise überlappt. Im Bereich der Intergrierten Schaltung des Mikrosystems dienen die untere und die obere leitende Schicht der Verdrahtung. Das Dielektrikum 4 ist derart strukturiert, daß es (nach dem isotropen Ätzprozeß) in den Zwischenraum zwischen den Kondensatorplatten einführbar bzw. aus ihm entfernbar ist. Aus der Schicht 7 kann außerdem eine Sicherung gegen das Herausfallen der später freizulegenden beweglichen Strukturen gebildet werden, beispielsweise indem ein geschlossener Bügel mit Hilfe der unterliegenden Schichten (s.FIG 3) gebildet wird, oder indem auf dem Kontakt 6 eine Fläche gebildet wird, die einen größeren Durchmesser als den entsprechenden Innendurchmesser des ringförmigen Dielektrikums 4 besitzt. Die obere leitende Schicht wird mit einer weiteren Isolation 8 (Passivierung) abgedeckt.

Es wird eine Maske 9 aufgebracht, die im BT-Bereich eine Öffnung oberhalb der freizulegenden beweglichen Struktur 4 aufweist, dann werden die isolierenden Schichten 3, 5, 8 geätzt. Dabei müssen folgende Bedingungen berücksichtigt werden:
- Der Ätzprozeß muß ausreichend selektiv zum Dielektrikum 4, den leitenden Schichten 2, 7 und in diesem Beispiel auch zum Kontakt 6 sein,
- die isotrope Komponente des Ätzprozesses und die Größe der Öffnung in der Maske müssen unter Berücksichtigung der einzelnen Schichtdicken so gewählt sein, daß das Dielektrikum 4 völlig unterätzt wird. Der Plattenzwi schenraum muß ebenfalls weit genug freigeätzt sein.

Der Ätzprozeß wird vorzugsweise als Naßätzung mit einer gepufferten HF-Lösung oder als mikrowellenunterstützte Trockenätzung durchgeführt.

Für die einzelnen Schritte des Herstellungsverfahrens können die aus der IS-Fertigung bekannten Prozesse und Materialien (bspw. Siliziumoxid als isolierende und Al-Legierungen als leitende Schicht) eingesetzt werden. Beispielsweise kann die Herstellung der Metallebene auch gleichzeitig mit der Auffüllung der Kontakte erfolgen, indem nach Ätzen der Kontaktlöcher in die entsprechende Isolationsschicht eine Haftschicht (beispielsweise 40nm Ti + 10Onm TiN) abgeschieden und dann in einem CVD-Prozeß Wolfram zur Kontaktlochauffüllung und gleichzeitig als Metallisierungsebenen aufgebracht wird.

Das Bauteil ist in ein Mikrosystem integriert, wobei die Herstellung der IS (z.B. Ansteuer- oder Auswerteschaltung in CMOS-Technologie) gleichzeitig mit dem beschriebenen Prozeß erfolgt. Dabei werden vorzugsweise folgende Punkte berücksichtigt:
- An dem Substrat 1 werden weitere, für die Herstellung der integrierten Schaltung notwendigen Verfahrensschritte vorgenommen, also beispielsweise Herstellen von epitaktischen Schichten, dotierten Wannen, Kanalimplantation, Gate-Oxid. Für die Gate-Ebene der IS kann die untere leitende Schicht 2 verwendet werden, für die Gate-Isolation (Zwischenoxid) bspw. die Schicht 3. Es wird u.a. eine Implantation der Source/Drain-Gebiete durchgeführt.
- Mithilfe der Kontakte 6 wird im IS-Bereich ein elektrischer Kontakt 6 der Metallisierungsebene 7 zur Gateebene 2 hergestellt.
   Im IS-Bereich dienen Kontakte 6 und die erste Metallisierungsebene beispielsweise auch zum Anschluß von S/D-Gebieten von Transistoren.
- Als isolierende Schichten werden vorzugsweise - in situ oder durch geeignete Prozesse - planare Schichten einge setzt. Planare Schichten sind auch im BT-Bereich vorteilhaft.
- Die weitere Isolation 8 besteht aus einer Passivierung aus Siliziumoxid und -nitrid.Die aufgebrachte Maske (9), die im BT-Bereich eine Öffnung oberhalb der freizulegenden beweglichen Struktur aufweist, besitzt im IS-Bereich oberhalb der von außen anzuschließenden Pads Öffnungen.

Im IS-Bereich muß die isotrope Ätzung auf diesen Anschluß-Pads stoppen.

Ein Ausschnitt aus einer solchen beispielhaften CMOSSchaltung ist in der deutschen Patentanmeldung DE OS 44 14 968 "Mikrosystem mit integrierter Schaltung und mikromechanischem Bauteil und Herstellverfahren" desselben Erfinders und desselben Anmelders in den Figuren 1 und 2(mit einer 2-Lagen-Metallisierung) dargestellt, auf die diesbezüglich verwiesen wird.

Das Mikrosystem kann als nicht-proportionaler Kraftsensor (Ereignissensor) universell eingesetzt werden. So kann die kapazitiv detektierte Lageveränderung des Ringes auch z.B. durch die Kraft von strömenden Medien oder direkte mechanische Einwirkung hervorgerufen werden.

### FIG 4 bis 6 :

Als zweites Beispiel wird ein Mikrosystem mit einem mikromechanischen Bauteil beschrieben, das als proportionaler Kraftsensor eingesetzt werden kann. Es umfaßt
- ein Kondensatorplattenpaar K, das aus einer oberen und einer unteren leitenden Schicht gebildet ist,
- ein Masse-Element M, das aus einer dielektrischen Schicht 4 gebildet, federnd aufgehängt und verschieden tief in den Plattenzwischenraum einführbar ist,
- ein Feder-Element F, welches auf einer Seite mit dem Masse-Element und auf der anderen Seite mit einer Befe stigungsplatte verbunden ist, und
- eine Befestigungsplatte B, die mit dem Substrat und dem Feder-Element verbunden ist.

Vorzugsweise werden Masse, Feder und Befestigungsplatte aus derselben Schicht gebildet. Es kann jedoch bei bestimmten Aufgabenstellungen auch vorteilhaft sein, beispielsweise Feder-Element und Befestigungsplatte aus leitenden Schichten herzustellen. Die Befestigungsplatte und die Kondensatorplatten stellen feste mikromechanische Strukturen dar, das Masse-Element und das Feder-Element (zumindest über einen ausreichenden Teil) bewegliche mikromechanische Strukturen. Die Befestigungsplatte übernimmt die Aufgabe einer mechanischen Verbindung des FederElementes mit dem Substrat. Die Befestigungsplatte B kann auch entfallen, wenn sichergestellt ist, daß die Feder über einen ausreichend großen Teil nicht unterätzt wird, sondern mit der unterliegenden isolierenden Schicht 3 mechanisch verbunden bleibt. Die Kondensatorplatten K können über Leitungen L mit einer Auswerteschaltung verbunden werden.

Das Bauteil kann mit dem beim ersten Beispiel beschriebenen Verfahren hergestellt werden, lediglich die Masken für die Strukturierung der dielektrischen Schicht 4 und für den isotropen Ätzprozeß (9) müssen angepaßt werden. Die Bezugsziffern für die einzelnen Schichten entsprechen denen in Fig. 1 - 3. Da das bewegliche Element nicht frei beweglich ist, ist die Sicherung gegen Herausfallen nicht vorgesehen und (im Bereich des Bauteils) kein Kontakt 6 vorhanden.

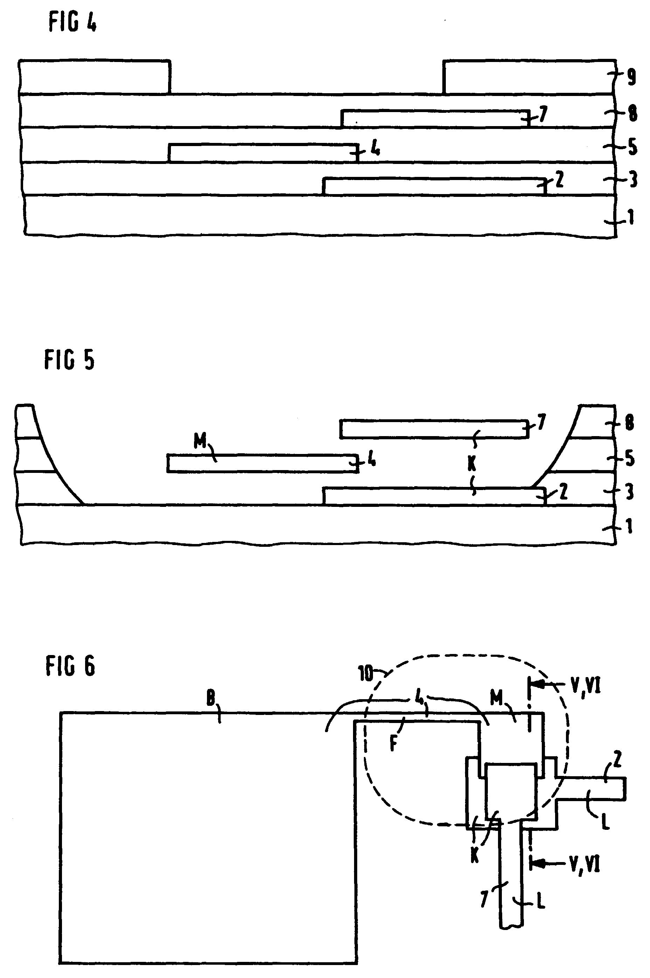

Die Photomaske 9 für den isotropen Ätzprozeß besitzt eine ausreichend große Öffnung, so daß wie bereits erläutert, mindestens das Masse-Element M und ein für die Federwirkung ausreichender Teil des Feder-Elementes F unterätzt werden (FIG 6). Ferner muß ein ausreichend großer Zwischenraum zwischen den Kondensatorplatten 2,7 freigeätzt werden. Die Befestigungsplatte B wird vorzugsweise nicht frei- oder unterätzt, um eine sichere mechanische Befestigung über die isolierende Schicht 3 mit dem Substrat 1 zu gewährleisten. In Fig 6 ist der freigeätzte Bereich 10 gestrichelt dargestellt und mit 10 bezeichnet. Die isolierenden Schichten sind nicht dargestellt.

Die Kondensatorplatten können auch im wesentlichen nebeneinanderliegend aus derselben leitenden Schicht gebildet werden, und Masse-Element M und Feder-Element F können derart zwischen den Platten gebildet sein, daß die Masse im wesentlichen senkrecht zur Substratoberfläche beweglich ist.

Dieses Bauteil ist wie das erste Ausführungsbeispiel in ein Mikrosystem integriert, wobei die Kondensatorplatten aus der oder den Verdrahtungsebene(n) gebildet werden. Die Leitungen L können aus einer höheren Verdrahtungsebene als die übrigen Strukturen hergestellt werden.

Wirkt auf das Masse-Element eine Kraft, so verbiegt sich die Feder F, und das Masse-Element verändert seinen Ort. Die Ortsveränderung kann als Kapazitätsänderung (Änderung von εᵣ) zwischen den Kondensatorplatten nachgewiesen werden. Durch die Rückstellkraft der Feder verändert sich das Kapazitätssignal monoton mit der einwirkenden Kraft. Das Bauelement kann daher als Beschleunigungssensor benutzt werden, indem man die Trägheitskraft auf das Masse-Element ausnutzt. Es ist jedoch genauso möglich, andere Krafteinwirkungen auf das Masse-Element zu detektieren. So können z.B. die Kraft einer strömenden Flüssigkeit oder eines Gases oder die direkte Krafteinwirkung eines externen mechanischen Bauteils nachgewiesen werden.

Weiterhin kann das Bauteil als Aktuator eingesetzt werden, indem man eine Spannung zwischen den Kondensatorplatten anlegt. Das elektrische Feld übt eine Kraft auf das Masse-Element aus und bewirkt eine Verschiebung. Insbesondere kann auch eine Wechsel-Spannung an die Kondensatorplatten angelegt werden, wodurch das dielektrische Masse-Element zu Schwingungen angeregt wird (Oszillator-Funktion). Da die mechanischen Schwingungsamplituden bei Anregung mit der Feder-Masse-System-Eigenfrequenz maximal werden, und zu einem Extremwert im Wechstromwiderstand führen, kann das Bauteil als frequenzbestimmendes Element in einer elektronischen Schaltung verwendet werden (Resonator).

## Patentansprüche

1. Mikrosystem auf einem Halbleitersubstrat (1) mit
- einem mikromechanischen Bauteil (BT) mit einer festen mikromechanischen Struktur, die ein aus einer oder mehreren leitenden Schichten (2,7) gebildetes Kondensatorplattenpaar (K) umfaßt, und mit einer beweglichen mikromechanischen Struktur, die aus einer dielektrischen Schicht (4) gebildet ist und in dem Plattenzwischenraum beweglich ist , und
- einer integrierten Schaltung (IS) mit Schaltungselementen, die mithilfe der leitenden Schicht oder mindestens einer der leitenden Schichten (7) verdrahtet sind.

2. Mikrosystem nach Anspruch 1, bei dem die bewegliche mikromechanische Struktur federnd beweglich ist, und das Bauteil einen proportionalen Kraftsensor, einen Aktuator oder einen Oszillator/Resonator darstellt.

3. Mikrosystem nach Anspruch 1, bei dem die bewegliche mikromechanische Struktur frei beweglich ist.

4. Mikrosystem nach Anspruch 3, bei dem das Bauteil (BT) einen Motor mit dielektrischem Rotor darstellt.

5. Mikrosystem nach Anspruch 3, bei dem die bewegliche mikromechanische Struktur in den Plattenzwischenraum einführbar oder aus ihm entfernbar ist, und das Bauelement einen nicht-proportionalen Kraftsensor darstellt.

6. Mikrosystem nach einem der Ansprüche 1 bis 5, bei dem die integrierte Schaltung (IS) mehrere leitende Schichten in Form einer Mehrlagenmetallisierung aufweist und die festen mikromechanischen Strukturen aus mehreren der Metallisierungsebene gebildet sind.

7. Mikrosystem nach einem der Ansprüche 1 bis 6, bei dem die integrierte Schaltung (IS) eine Ein- oder Mehrlagenmetallisierung mit der leitenden Schicht 7 aufweist und die festen mikromechanischen Strukturen aus derselben leitenden Schicht (7) gebildet sind.

8. Mikrosystem nach einem der Ansprüche 1, 3 bis 7 , bei dem Sicherungsmittel gegen Herausfallen der frei beweglichen mikromechanischen Struktur vorgesehen sind, die mit Hilfe mindestens einer der Metallisierungsebenen gebildet sind.

9. Mikrosystem nach einem der Ansprüche 1 8, bei dem die leitende Schicht (7) oder die leitenden Schichten (2, 7) aus einer Aluminiumlegierung oder im wesentlichen aus Wolfram bestehen und die isolierende Schicht (5) oder die isolierenden Schichten (3, 5, 8) aus einem Siliziumoxid besteht bzw. bestehen.

10. Herstellverfahren für ein Mikrosystem nach einem der Ansprüche 1 bis 9, bei dem
- die feste mikromechanische Struktur durch eine Strukturierung der leitenden Schicht (7) erzeugt wird, die gleichzeitig mit der Strukturierung der leitenden Schicht (7) im Bereich der integrierten Schaltung erfolgt,
- mindestens ein Teil des Plattenzwischenraums und die bewegliche mikromechanische Struktur durch Entfernung einer isolierenden Schicht (3,5), die die feste und die bewegliche mikromechanische Struktur trennt, in einem Ätzprozeß freigelegt wird, wobei der Ätzprozeß eine ausreichende Selektivität zur leitenden Schicht (7 )und zur dielektrischen Schicht (4) aufweist und eine isotrope Komponente besitzt.

11. Herstellverfahren nach Anspruch 15, bei dem als Ätzprozeß eine mikrowellenunterstützte isotrope Trockenätzung durchgeführt wird.

12. Herstellverfahren nach Anspruch 13, bei dem im Ätzprozeß eine gepufferte HF-LÖsung verwendet wird.

13. Herstellverfahren nach einem der Ansprüche 10 bis 12, bei dem die integrierte Schaltung (IS) und das mikromechanische Bauteil (BT) mit mehreren leitenden Schichten (2,7,) hergestellt werden, die mit weiteren isolierenden Schichten (3,5,8) abgedeckt werden, und bei dem der Ätzprozeß die isolierenden Schichten mit ausreichender Selektivität zu den leitenden Schichten ätzt.
